# EUROPÄISCHE PATENTSCHRIFT

(11) **EP 3 116 883 B1**
(45) Veröffentlichungstag und Bekanntmachung des Hinweises auf die Patenterteilung: **14.08.2019**
(21) Anmeldenummer: 15709677.7
(22) Anmeldetag: 12.03.2015
(51) Int. Cl.: C23C 16/18, C07F 5/00, H01L 21/02

(54) **VERFAHREN ZUR HERSTELLUNG VON TRIALKYLGALLIUM-VERBINDUNGEN UND DEREN VERWENDUNG**
METHOD FOR THE PREPARATION OF TRIALKYL GALLIUM COMPOUNDS AND THEIR USE
PROCÉDÉ DE FABRICATION DE COMPOSÉS TRIALKYLGALLIUM ET LEUR UTILISATION

(30) Priorität: 14.03.2014 EP 14159973
(43) Veröffentlichungstag der Anmeldung: 18.01.2017
(73) Patentinhaber: Umicore AG & Co. KG, 63457 Hanau-Wolfgang (DE)
(72) Erfinder: SCHORN, Wolf, 35396 Giessen (DE); SUNDERMEYER, Joerg, 35041 Marburg (DE); FREY, Annika, 63457 Hanau (DE); KARCH, Ralf, 63801 Kleinostheim (DE); RIVAS-NASS, Andreas, 64625 Bensheim (DE); WOERNER, Eileen, 61130 Nidderau (DE); DOPPIU, Angelino, 63500 Seligenstadt (DE)
(86) Internationale Anmeldenummer: PCT/EP2015/055211
(87) Internationale Veröffentlichungsnummer: WO 2015/136049

(56) Entgegenhaltungen:
- EP-A1- 0 399 190
- WO-A1-2012/150229
- WO-A1-2014/093419
- US-A- 5 663 390
- O. T. BEACHLEY ET AL: "Synthesis and Characterization of Monomeric Organogallium-Nitrogen Compounds, Et 2 GaNMe[C 6 H 2 (2,4,6-t-Bu) 3 ], Me 2 GaNMe[C 6 H 2 (2,4,6-t-Bu) 3 ], MeGa{NH[C 6 H 2 (2,4,6-t-Bu) 3 ]} 2 , and Ga{NH[C 6 H 2 (2,4,6-t-Bu) 3 ]} 3", ORGANOMETALLICS, Bd. 20, Nr. 5, 1. März 2001 (2001-03-01), Seiten 945-949, XP055007983, ISSN: 0276-7333, DOI: 10.1021/om001050f
- CHARLES L. B. MACDONALD ET AL: "Group 13 decamethylmetallocenium cations", DALTON TRANSACTIONS, Nr. 9, 1. Januar 2008 (2008-01-01), Seite 1161, XP055133945, ISSN: 1477-9226, DOI: 10.1039/b716220k
- JOLIN A. JEGIER ET AL: "Bis(dimethylamido) Complexes of Alkyl- and Phenylgallium. Useful Precursors to the RGa 2+ Synthon", INORGANIC CHEMISTRY, Bd. 40, Nr. 23, 1. November 2001 (2001-11-01), Seiten 6017-6021, XP055133992, ISSN: 0020-1669, DOI: 10.1021/ic010724r
- O. T. BEACHLEY ET AL: "Monomeric Organogallium-Nitrogen Compounds. Chemistry of Et 2 GaNH[C 6 H 2 (2,4,6-t-Bu) 3 ] with Decomposition to the Metallacycle {EtGaNH[C 6 H 2 (4,6-t-Bu) 2 CMe 2 CH 2 -2]} 2 and of EtGa{NH[C 6 H 2 (2,4,6-t-Bu) 3 ]} 2", ORGANOMETALLICS, Bd. 18, Nr. 13, 1. Juni 1999 (1999-06-01), Seiten 2543-2549, XP055134002, ISSN: 0276-7333, DOI: 10.1021/om990136+
- GERALD LINTI ET AL: "Zur Chemie des Galliums, IV. Darstellung und Strukturen monomerer (2,2,6,6-Tetramethylpiperidino)gallane", CHEMISCHE BERICHTE, Bd. 127, Nr. 8, 1. August 1994 (1994-08-01), Seiten 1387-1393, XP055134009, ISSN: 0009-2940, DOI: 10.1002/cber.19941270810
- H. KRAUSE ET AL: "Methylmetall-bis(trimethylsilyl)amidoderi vate des Aluminiums, Galliums und Arsens", ZEITSCHRIFT F&#XFFFD;R ANORGANISCHE UND ALLGEMEINE CHEMIE, Bd. 563, Nr. 1, 1. August 1988 (1988-08-01), Seiten 116-126, XP055134027, ISSN: 0044-2313, DOI: 10.1002/zaac.19885630116
- HUBERT SCHMIDBAUR ET AL: "Neue Wege zu Organogalliumhalogeniden", CHEMISCHE BERICHTE, Bd. 99, Nr. 7, 1. Juli 1966 (1966-07-01), Seiten 2187-2196, XP055128271, ISSN: 0009-2940, DOI: 10.1002/cber.19660990717 in der Anmeldung erwähnt

## Beschreibung

Gegenstand der Erfindung ist ein Verfahren zur Herstellung von Trialkylgallium-Verbindungen. Dabei wird Alkylgalliumdichlorid, bzw. eine Dialkylgalliumchlorid/Alkylgalliumdichlorid-Mischung hergestellt, aus dem anschließend Trialkylgallium-Verbindungen erhältlich sind.

Trialkylgallium-Verbindungen werden insbesondere als metallorganische Präkursoren für die metallorganische chemische Gasphasenabscheidung (MOCVD; metal organic chemical vapour deposition) oder die metallorganische Gasphasenepitaxie (MOVPE; metal organic chemical vapor phase epitaxy) verwendet.

### Stand der Technik

Im Stand der Technik sind verschiedene Verfahren zur Herstellung von Präkursoren für MOCVD- beziehungsweise MOVPE-Verfahren beschrieben. Diese Prozesse werden insbesondere bei der Herstellung von Filmen für optoelektronische Anwendungen wie Solarzellen oder LEDs eingesetzt, was üblicherweise höchste Reinheit des jeweils verwendeten metallorganischen Präkursors sowie die Abwesenheit beziehungsweise das Vorhandensein nur sehr geringer Anteile an sauerstoffhaltigen Verunreinigungen erfordert.

So sind verschiedene Verfahren zur Herstellung von Trialkylindium-, Trialkylgallium- oder auch Trialkylaluminium-Verbindungen bekannt. Die jeweiligen Verfahrensbedingungen sind allerdings nicht zwingend beziehungsweise nicht unverändert übertragbar. Es ist zu berücksichtigen, dass die Elemente Aluminium, Gallium und Indium bereits ein unterschiedliches chemisches Verhalten zeigen, woraus sich regelmäßig der Bedarf einer jeweils angepassten, besonderen Verfahrensführung bei Herstellung von Trialkylindium-, Trialkylgallium- oder Trialkylaluminium-Verbindungen ergibt.

Im Stand der Technik bekannte Verfahren zur Herstellung von Trialkylgallium-Verbindungen stoßen oft auf erhebliche Schwierigkeiten, wenn es um die Herstellung in der für übliche Verwendungen erforderlichen Reinheit und Menge an Trialkylgallium-Verbindungen, insbesondere Trimethylgallium, geht. So können die elektrischen Eigenschaften der aus den Präkursoren über MOCVD oder MOVPE hergestellten Halbleiterschichten durch Verunreinigungen in den Präkursoren erheblich nachteilig beeinträchtigt werden. Zahlreiche Verfahren sind zudem sehr zeitaufwändig. Auch werden häufig nur geringe Ausbeuten erzielt und die Reaktionsschritte sind häufig durch eine verminderte Selektivität gekennzeichnet. Auch aufgrund der Verwendung hoher Mengen organischer Lösungsmittel bei bekannten Verfahren sind diese zumeist kostenintensiv, wenig umweltfreundlich und gehen mit Lösungsmittelresten in den Zwischenprodukten und den Endprodukten einher, die wiederum die Verwendung der Endprodukte erheblich einschränken können oder eine kostenintensive und aufwändige Aufreinigung erforderlich machen. Auch wird teilweise Iod oder Brom als Aktivator bei der Herstellung von Alkylgallium-Verbindungen eingesetzt, was ebenfalls mit Verunreinigungen einhergeht, die die spätere Verwendung erheblich einschränken können. Einzelne Verfahren sehen zudem die Einleitung von H₂ vor, was die Verfahren zusätzlich aufwändig und kostenintensiv gestaltet.

WO 2013/083450 A1 betrifft ein Verfahren zur Herstellung von Trialkylgallium aus Galliumtrichlorid und einer Alkylaluminiumverbindung. Allerdings ist Galliumtrichlorid ein sehr teures Edukt, hygroskopisch und korrosiv, so dass aufwändige Maßnahmen ergriffen werden müssen, die ein solches Verfahren insgesamt sehr kostspielig gestalten.

US 5,663,390 betrifft ein Verfahren zur Herstellung von Organometallchloriden ausgehend von elementarem Metall. Als Metall ist auch Gallium verwendet. Dabei ist das Zuleiten von H₂ wesentlicher Verfahrensbestandteil zur ausreichenden Aktivierung der Reaktion, was das Verfahren insgesamt aufwändig und kostenintensiv gestaltet. Eine Ausbeute oder gar die Reinheit des genannten Reaktionsprodukts R₂GaCl ist nicht angegeben. Außerdem sind hohe Temperaturen zur Umsetzung von etwa 240°C vorgesehen, was das Verfahren apparativ aufwändig gestaltet.

WO 2012/150229 A1 beschreibt ein Verfahren zur Herstellung von Trialkylgallium, wobei Gallium mit einem Alkylchlorid in Anwesenheit einer Lewis-Säure als Katalysator zur Reaktion gebracht wird. Als Reaktionsprodukt ist Alkylgalliumsesquichlorid (R₃Ga₂Cl₃) beschrieben. Die Lewis-Säure wird insbesondere in-situ gebildet, wofür insbesondere Iod oder Brom zur Reaktionsmischung zugesetzt wird. Letzteres führt zu nicht tolerierbaren und insbesondere nur sehr schwer abtrennbaren Verunreinigungen im Reaktionsprodukt. Das erhaltene R₃Ga₂Cl₃ wird nicht isoliert und ohne weitere Charakterisierung direkt zu Trialkylgallium umgesetzt. Die Umsetzung erfolgt insgesamt nicht atomökonomisch.

Gynane und Worrall beschreiben die Umsetzung von Gallium mit einem Alkylbromid oder Alkyliodid zu Alkylgalliumsesquihaliden beziehungsweise einer Mischung aus Alkylgalliumdihaliden und Dialkylgalliumhaliden (M. J. S. Gynane, I. J. Worrall, J. Organomet. Chem, 1972, 40, C59). Die Reaktion findet bei Raumtemperatur statt und erfordert Reaktionszeiten von wenigstens zwei bis zu vier Wochen. Die beschriebenen Verfahrensbedingungen sind nicht auf die Reaktion von Gallium mit Alkylchloriden übertragbar. Ausbeuten sind nicht aufgeführt ebenso wie die Reinheit der erhaltenen Reaktionsprodukte.

Beachley et al., Organometallics 20 Nr. 5 (2001), 945 zeigt die Herstellung von MeGaCl₂ ausgehend von GaCl₃ und GaMe₃.

Eine Herstellung von Alkylgalliumverbindungen ist ferner von Schmidbaur und Findeiss beschrieben. Dabei wird Methylgalliumdichlorid ausgehend von GaCl₃ und Me₄Si oder GaCl₃ und (Me₃Si)₂O hergestellt (H. Schmidbaur, W. Findeiss, Chem. Ber. 1966, 99, 2187). Auch diese Herstellung ist allerdings aufgrund der Edukte kostenintensiv und daher wenig für den industriellen Maßstab geeignet.

### Aufgabe

Es ist eine Aufgabe der vorliegenden Erfindung ein Verfahren bereitzustellen, dass eine kostengünstige Herstellung von Trialkylgallium-Verbindungen ermöglicht bei einfacher und schneller Prozessführung. Auch soll das Verfahren die Herstellung von Trialkylgallium-Verbindungen mit hoher Ausbeute und hoher Reinheit ermöglichen. Insbesondere sollen die Trialkylgallium-Verbindungen möglichst frei von Sauerstoffverunreinigungen sein.

Die hergestellten Trialkylgallium-Verbindungen sollen hierdurch besonders als metallorganischer Präkursor für die metallorganische chemische Gasphasenabscheidung (MOCVD) oder die metallorganische Gasphasenepitaxie (MOVPE) geeignet sein, was für die Herstellung von Halbleiterschichten jeweils hochreine Organometallverbindungen erfordert.

Das Verfahren soll zudem wenig umweltbelastend und ressourcenschonend durchführbar sein.

### Lösung

Die Aufgabe der vorliegenden Erfindung wird durch die Gegenstände der Patentansprüche gelöst. Die Aufgabe wird insbesondere gelöst durch ein verbessertes Verfahren zur Herstellung einer Verbindung (A), welche entweder der allgemeinen Formel RGaCl₂ entspricht oder eine Mischung ist von RGaCl₂ mit R₂GaCl, umfassend die Reaktionsschritte
a1) Reaktion von Gallium mit einem Alkyldonor in Anwesenheit eines Aktivators zur Bildung von Verbindung (A),
a2) und optional Isolierung der Verbindung (A) vom Reaktionsgemisch,
wobei R ein verzweigter oder unverzweigter Alkylrest mit 1 bis 4 Kohlenstoffatmen ist und die Zugabe des Alkyldonors mit der allgemeinen Formel RCl bei einem vorgegebenem konstantem Druck von 1,5 bis 6 bar erfolgt, wobei R wie oben definiert ist und in Schritt a1) gasförmig vorliegt, und der Aktivator eine Verbindung oder eine Mischung von Verbindungen der allgemeinen Formel RₐGa_{b}Cl_{c} ist, wobei a eine Zahl ausgewählt aus 0, 1, 2 und 3 ist und b eine Zahl ausgewählt aus 1 und 2 ist und c eine Zahl ausgewählt aus 0, 1, 2 und 3 ist, wobei a und c nicht gleichzeitig 0 sind, und wobei a + b + c = 4 oder ein Vielfaches von 4 sind und wobei R wie oben definiert ist und wobei die Summe aus a und c gleich 3 ist, wenn b gleich 1 ist, oder wobei die Summe aus a und c gleich 6 ist, wenn b gleich 2 ist.

### Kurze Beschreibung der Erfindung

1. Verfahren zur Herstellung einer Verbindung (A), welche entweder der allgemeinen Formel
   RGaCl₂ entspricht oder eine Mischung ist von RGaCl₂ mit R₂GaCl, umfassend die Reaktionsschritte
      a1) Reaktion von Gallium mit einem Alkyldonor in Anwesenheit eines Aktivators zur Bildung von Verbindung (A),;
      a2) und optional Isolierung der Verbindung (A) vom Reaktionsgemisch,
   wobei R ein verzweigter oder unverzweigter Alkylrest mit 1 bis 4 Kohlenstoffatomen ist und die Zugabe des Alkyldonors bei einem vorgegebenem konstantem Druck von 1,5 bis 6 bar erfolgt,
   der Alkyldonor die allgemeine Formel hat:

      **RCl**

      wobei R wie oben definiert ist und in Schritt a1) gasförmig vorliegt, und
   der Aktivator eine Verbindung oder eine Mischung von Verbindungen folgender allgemeiner Formel ist:

      **RₐGa_{b}Cl_{c},**

      wobei a eine Zahl ausgewählt aus 0, 1, 2 und 3 ist und b eine Zahl ausgewählt aus 1 und 2 ist und c eine Zahl ausgewählt aus 0, 1, 2 und 3 ist, wobei a und c nicht gleichzeitig 0 sind, und wobei a + b + c = 4 oder ein Vielfaches von 4 sind und wobei R wie oben definiert ist und wobei die Summe aus a und c gleich 3 ist, wenn b gleich 1 ist, oder wobei die Summe aus a und c gleich 6 ist, wenn b gleich 2 ist.
2. Verfahren nach Punkt 1, wobei der Aktivator ausgewählt ist aus GaCl₃, R₂GaCl, R₃Ga₂Cl₃, RGaCl₂, und Mischungen davon, oder bevorzugt das Reaktionsprodukt, Verbindung A, selbst ist.
3. Verfahren nach einem der vorangegangenen Punkte, wobei der Aktivator ausgewählt ist aus RGaCl₂, GaCl₃, R₃Ga₂Cl₃ und Mischungen davon.
4. Verfahren nach einem der vorangegangenen Punkte, wobei R Methyl oder Ethyl ist, vorzugsweise Methyl.
5. Verfahren nach einem der vorangegangenen Punkte, wobei das Molverhältnis von Alkyldonor zu Gallium wenigstens 1,4:1 beträgt.
6. Verfahren nach wenigstens einem der vorangegangenen Punkte, wobei eine Vormischung aus Gallium und Aktivator im Reaktionsschritt a1) im Reaktionsgefäß vorgelegt wird und der Alkyldonor anschließend zugesetzt wird.
7. Verfahren nach Punkt 8, wobei die Eduktmischung auf Temperaturen zwischen 120°C und 200°C erhitzt wird.
8. Verfahren nach Punkt 9, wobei die Temperaturen für wenigstens 30 min und höchstens 50 Stunden aufrechterhalten werden.
9. Verfahren nach einem der vorangegangenen Punkte, wobei der Reaktionsschritt a1) unter Abwesenheit organischer Lösungsmittel durchgeführt wird.
10. Verfahren nach einem der vorangegangenen Punkte, wobei Schritt a) die Isolierung der Verbindung (A) vom Reaktionsgemisch als Reaktionsschritt a2) umfasst, und wobei die Isolierung der Verbindung (A) vom Reaktionsgemisch ein Abtrennen nicht umgesetzter Edukte vom Reaktionsgemisch umfasst.
11. Verfahren nach einem der vorangegangenen Punkte, wobei die Ausbeute an Verbindung (A) über 90% bezogen auf eingesetztes Gallium-Metall beträgt.
12. Verfahren nach einem der vorangegangenen Punkte, wobei die Reinheit der Verbindung (A) mehr als 99% beträgt.
13. Verfahren zur Herstellung einer Verbindung (B) der allgemeinen Formel:

   **R₃Ga**

   wobei eine Verbindung (A) nach einem oder mehreren der vorstehenden Punkte bereitgestellt wird, und
   b) Reaktion der Verbindung (A) mit einer Metallalkyl-Komponente, wobei eine Verbindung (B) der allgemeinen Formel:

   **R₃Ga**

   erhalten wird, wobei R wie in einem der vorstehenden Punkte definiert ist.
14. Verfahren nach Punkt 13, wobei die Metallalkyl-Komponente die allgemeine Formel aufweist:

   **R_{d}MₑX_{f}**

   wobei d eine Zahl ausgewählt aus 1, 2 und 3 ist und e eine Zahl ausgewählt aus 1 und 2 ist und f eine Zahl ausgewählt aus 0, 1, 2 und 3 ist, und wobei d und f nicht gleichzeitig 0 sind, und wobei R wie oben definiert ist, und wobei M ausgewählt ist aus Aluminium, Lithium und Magnesium, und wobei X ausgewählt ist aus Cl, Br und I.
15. Verfahren nach Punkt 14, wobei M Aluminium ist, e = 1 oder 2 ist und die Summe aus d, e und f = 4 oder 8 ist, und wobei d ≠ 0 ist, und wobei X = Cl ist.
16. Verfahren nach einem der Punkte 13 bis 14, wobei die Metallalkyl-Komponente ausgewählt ist aus RMgCl, R₂AlCl, R₃Al, R₃Al₂Cl₃ und RLi, insbesondere Me₃Al, Et₃Al, Me₃Al₂Cl₃ und Et₃Al₂Cl₃.
17. Verfahren nach einem der Punkte 13 bis 16, wobei im Reaktionsschritt b) ferner eine Hilfsbase zugesetzt wird, wobei die Hilfsbase ausgewählt ist aus Natriumchlorid, Kaliumchlorid, Aluminiumchlorid und Mischungen davon.
18. Verfahren nach einem der Punkte 13 bis 17, wobei die Ausbeute an Verbindung (B) über 90% beträgt.
19. Verfahren nach einem der Punkte 13 bis 18, wobei die Reinheit der Verbindung (B) wenigstens 99% beträgt.
20. Verfahren nach einem oder mehreren der Punkte 1 bis 19, wobei die Verbindung (A) eine Mischung der Verbindungen R₂GaCl und RGaCl₂ is, wobei R wie oben definiert ist und das Verhältnis von R₂GaCl zu RGaCl₂ von 10:90 bis 90:10, insbesondere 10:90 bis 50:50, insbesondere von 20:80 bis 40:60, bezogen auf die molaren Mengen beträgt.

### Detaillierte Beschreibung der Erfindung

Die Herstellung der Trialkylgallium-Verbindung erfolgt erfindungsgemäß über die Zwischenstufe, Verbindung (A), welche Alkylgalliumdichlorid bzw. eine Dialkylgalliumchlorid/Alkylgalliumdichlorid-Mischung sein kann:

RGaCl₂, bzw. R₂GaCl/RGaCl₂

wobei R ein Alkylrest mit 1 bis 4 Kohlenstoffatomen ist. Das Verhältnis zwischen R₂GaCl und RGaCl₂ liegt bei 10:90 bis 90:10, insbesondere 10:90 bis 50:50, insbesondere 20:80 bis 40:60, bezogen auf die molaren Mengen. Der Alkylrest kann verzweigt oder unverzweigt sein, bevorzugt unverzweigt. R ist vorzugsweise ausgewählt aus Ethyl und Methyl, ganz besonders bevorzugt ist R Methyl. Das nach dem erfindungsgemäßen Verfahren mit schneller Prozessführung und in hoher Ausbeute und Reinheit erhältliche RGaCl₂ bzw. R₂GaCl/RGaCl₂ kann anschließend zur Herstellung von erfindungsgemäßen Trialkylgallium-Verbindungen verwendet werden.

Dies wiederum ermöglicht die Herstellung von Trialkylgallium-Verbindungen ausgehend von elementarem Gallium mit hoher Reinheit und hoher Ausbeute bei schneller Prozessführung.

Durch die gezielte Verwendung kostengünstiger und wenig umweltschädlicher Ausgangsstoffe und weiterer Reagenzien ist das erfindungsgemäße Verfahren ferner auch im industriellen Maßstab kostensparend und umweltschonend durchführbar. Insbesondere kann erfindungsgemäß weitgehend auf den Einsatz üblicherweise erforderlicher organischer Lösungsmittel verzichtet werden, was zu einer kosteneffektiven und umweltschonenden Verfahrensführung beiträgt.

Insbesondere im Vergleich mit im Stand der Technik bekannten Verfahren, die von GaCl₃ ausgehen, ermöglicht das erfindungsgemäße Verfahren eine kostengünstigere und schnellere Herstellung von Trialkylgallium-Verbindungen und ist somit besser für den industriellen Maßstab geeignet.

Die hergestellten Trialkylgallium-Verbindungen sind aufgrund der besonders hohen Reinheit besonders geeignet für die Herstellung von galliumhaltigen Filmen in der Halbleiterindustrie und in verwandten Elektronikindustrie, im Rahmen der metallorganisch chemischen Gasphasenabscheidung (MOCVD) oder der metallorganischen Gasphasenepitaxie (MOVPE).

Das erfindungsgemäße Verfahren umfasst den Schritt:
a) Herstellung von Alkylgalliumdichlorid bzw. einer R₂GaCl/RGaCl₂-Mischung.

An Schritt a) kann sich als weiterer Schritt anschließen:
b) Herstellung der Trialkylgallium-Verbindung aus Alkylgalliumdichlorid bzw. R₂GaCl/RGaCl₂-Mischung.

Schritt b) kann dabei unmittelbar auf Schritt a) folgen oder zeitlich versetzt, also bedarfsgerecht im Anschluss an Schritt a) durchgeführt werden.

Es hat sich als besonders vorteilhaft erwiesen, Trialkylgallium-Verbindungen über die Zwischenstufe Verbindung (A), Alkylgalliumdichlorid (RGaCl2) bzw. R₂GaCl/RGaCl₂-Mischung, herzustellen. Diese kann erfindungsgemäß mit hoher Reinheit hergestellt werden. RGaCl₂ bzw. R₂GaCl/RGaCl₂-Mischung wird ferner in guter Ausbeute erhalten und ist einfach isolierbar, so dass von dieser Zwischenstufe ausgehend schnell und gesteuert Trialkylgallium-Verbindung herstellbar ist.

Zum anderen konnten besonders reine Trialkylgallium-Verbindungen in hoher Ausbeute und kurzer Verfahrensdauer bei einer solchen Verfahrensführung hergestellt werden. Erfindungsgemäß ist daher die Herstellung von RGaCl₂ bzw. R₂GaCl/RGaCl₂-Mischung umfassend Schritt a), an die sich wiederum die Herstellung der Trialkylgallium-Verbindung umfassend Schritt b) anschließen kann. Durch Verwendung von RGaCl₂ bzw. R₂GaCl/RGaCl₂-Mischung als Zwischenstufe bei der Herstellung von Trialkylgallium-Verbindungen kann weitgehend auf den Einsatz von üblichen und kostenintensiven Edukten zur Herstellung von Trialkylgallium-Verbindungen verzichtet werden, insbesondere auf die Verwendung hoher Mengen von GaCl₃, was in bisher bekannten Verfahren üblicherweise erforderlich ist. Ferner weist RGaCl₂ bzw. R₂GaCl/RGaCl₂-Mischung bereits eine bzw. mehrere Alkylgruppen auf, so dass die Mengen an Alkylierungsmitteln, die üblicherweise zur Herstellung von Trialkylgallium eingesetzt werden, mit dem erfindungsgemäßen Verfahren deutlich vermindert werden kann.

### a) Herstellung von Alkylgalliumdichlorid

Die Herstellung von RGaCl₂ bzw. R₂GaCl/RGaCl₂-Mischung umfasst folgenden Reaktionsschritt:
a1) Reaktion von elementarem Gallium mit einem Alkyldonor in Anwesenheit eines Aktivators zur Bildung von RGaCl₂; bzw. R₂GaCl/RGaCl₂-Mischung
a2) und optional Isolieren des RGaCl₂ bzw. der R₂GaCl/RGaCl₂-Mischung vom Reaktionsgemisch.

In bevorzugten Ausführungsformen umfasst die erfindungsgemäße Herstellung von RGaCl₂ bzw. der R₂GaCl/RGaCl₂-Mischung den Schritt a2), es erfolgt also eine Isolierung des RGaCl₂ bzw. der R₂GaCl/RGaCl₂-Mischung vom Reaktionsgemisch. Der Begriff "Isolierung" beziehungsweise "Isolieren" umfasst das Abtrennen des jeweils gewünschten Reaktionsproduktes vom im Reaktionsgefäß befindlichen Gemisch durch Entfernen des Reaktionsproduktes aus dem Reaktionsgefäß oder das Entfernen sonstiger Verbindungen neben dem Reaktionsprodukt vom Gemisch derart, dass das Reaktionsprodukt im Reaktionsgefäß zurückbleibt.

In alternativen Ausführungsformen umfasst der erfindungsgemäße Schritt a) keinen Reaktionsschritt a2), es erfolgt also keine Isolierung der Verbindung (A), RGaCl₂ bzw. R₂GaCl/RGaCl₂-Mischung, aus dem Reaktionsgemisch. In solchen Ausführungsformen kann sich also Schritt b) an Schritt a) anschließen ohne vorherige Isolierung von RGaCl₂ bzw. R₂GaCl/RGaCl₂-Mischung vom Reaktionsgemisch.

### Reaktionsschritt a1):

Der Alkyldonor ist erfindungsgemäß eine Verbindung, die eine Alkylgruppe umfasst, wobei es sich bei dem Alkyldonor erfindungsgemäß um ein Alkylchlorid handelt, das also neben der Alkylgruppe auch wenigstens ein Chloratom umfasst. Daher hat der Alkyldonor folgende allgemeine Formel:

**RCl**,

wobei R wie oben definiert ist. Solche Alkyldonoren sind kostengünstig verfügbar im Vergleich beispielsweise mit Alkyllithiumverbindungen. R ist besonders bevorzugt ausgewählt aus Methyl und Ethyl, weiter bevorzugt ist R Methyl. Der Alkyldonor ist also besonders bevorzugt Methylchlorid.

Bevorzugt beträgt das Molverhältnis von Alkyldonor zu Gallium wenigstens 1,4:1, bevorzugt wenigstens 1,6:1 und besonders bevorzugt wenigstens 1,7:1 sowie noch mehr bevorzugt wenigstens 1,8:1. Ist das Molverhältnis von Alkyldonor zum Gallium zu niedrig, so besteht die Gefahr einer unvollständigen Reaktion und einer verminderten Ausbeute an RGaCl₂ bzw. R₂GaCl/RGaCl₂-Mischung. Das Molverhältnis sollte aber höchstens 5:1, weiter bevorzugt höchstens 4,5:1 und noch mehr bevorzugt höchstens 4:1 betragen. Ist das Molverhältnis von Alkyldonor zum Gallium zu hoch, so besteht die Gefahr, dass das Verfahren insgesamt zu teuer wird. Besonders gute Ausbeutern an RGaCl₂ bzw. R₂GaCl/RGaCl₂-Mischung konnten erzielt werden bei einem Molverhältnis von Alkyldonor zu Gallium zwischen 1,8:1 und 3,8:1, insbesondere zwischen 1,9:1 und 3,7:1.

Erfindungsgemäß wird bei der Reaktion von Gallium und dem Alkyldonor ein Aktivator zugesetzt. Dies ermöglicht hohe Ausbeuten und eine hohe Reinheit an RGaCl₂ bzw. R₂GaCl/RGaCl₂-Mischung. Es wird vermutet, dass die erfindungsgemäßen Aktivatoren in der Lage sind, zur Bildung von reaktiven Gallium(I)-Spezies beizutragen, die wiederum in der Lage sind, den Alkyldonor unter oxidativer Addition zu RGaCl₂ bzw. R₂GaCl zu addieren.

Der erfindungsgemäße Aktivator ist eine Verbindung oder eine Mischung von Verbindungen mit folgender allgemeiner Formel

**RₐGa_{b}Cl_{c},**

wobei a eine Zahl ausgewählt aus 0, 1, 2 und 3 ist und b eine Zahl ausgewählt aus 1 und 2 ist und c eine Zahl ausgewählt aus 0, 1, 2 und 3 ist, wobei a und c nicht gleichzeitig 0, und wobei a + b + c = 4 oder ein Vielfaches von 4 sind, besonders bevorzugt die Summe aus a, b und c = 4 oder 8 ist und wobei R wie oben definiert ist und wobei die Summe aus a und c gleich 3 ist, wenn b gleich 1 ist, oder wobei die Summe aus a und c gleich 6 ist wenn b gleich 2 ist.

Ganz besonders bevorzugt ist der Aktivator ausgewählt aus Galliumtrichlorid (GaCl₃), Dialkylgalliumchlorid (R₂GaCl), R₃Ga₂Cl₃, RGaCl₂, und Mischungen davon. Solche erfindungsgemäßen Aktivatoren haben sich als besonders vorteilhaft erwiesen. Ganz besonders bevorzugt ist der Aktivator das Reaktionsprodukt.

In einer besonders bevorzugten Ausführungsform ist der Aktivator R₃Ga₂Cl₃. R₃Ga₂Cl₃ kann in-situ erzeugt werden, besonders bevorzugt durch Herstellung einer Mischung von GaCl₃ und R₃Ga. In solchen Ausführungsformen wird eine Mischung von GaCl₃ und R₃Ga als Aktivatorvorstufe verwendet, wobei in-situ R₃Ga₂Cl₃ erzeugt wird. Das Molverhältnis von GaCl₃ zu R₃Ga liegt in Ausführungsformen, in denen der Aktivator R₃Ga₂Cl₃ beziehungsweise eine Mischung von GaCl₃ und R₃Ga ist, vorzugsweise zwischen 0,5:1 und 1,5:1, weiter bevorzugt zwischen 0,7:1 und 1,3:1 und besonders bevorzugt zwischen 0,8:1 und 1,2:1. Ein solches Molverhältnis hat sich als besonders vorteilhaft erwiesen.

In alternativen Ausführungsformen ist der Aktivator das Reaktionsprodukt RGaCl₂ bzw. R₂GaCl/RGaCl₂-Mischung. Dies bietet den zusätzlichen Vorteil, dass ein für die erfindungsgemäße Reaktion verwendetes Reaktionsgefäß erneut eingesetzt werden kann und noch enthaltene Reste von Verbindung (A), RGaCl₂ oder ein R₂GaCl/RGaCl₂-Gemisch, die nicht isoliert wurden, bereits als Aktivator wirken. Ein Vorteil dieser Vorgehensweise ist eine semikontinuierliche Verfahrensführung, bei welcher nur ein Teil des Reaktionsproduktes aus dem Reaktor entnommen wird und wobei nach Zugabe von frischem Gallium die Reaktion zur Herstellung von Verbindung (A) fortgesetzt werden kann. Dadurch kann das erfindungsgemäße Verfahren noch kosteneffektiver gestaltet werden.

In einer weiteren alternativen Ausführungsform ist der Aktivator GaCl₃ oder eine Mischung von GaCl₃ und RGaCl₂.

Das Molverhältnis von Gallium zu dem Aktivator beträgt vorzugsweise mehr als 1:1, bevorzugt wenigstens 1,1:1 und weiter bevorzugt wenigstens 1,2:1. Bei einem niedrigeren Verhältnis von <1:1 wird das Verfahren zu teuer und ineffizient. Das Molverhältnis von Gallium zu Aktivator beträgt vorzugsweise höchstens 50:1, bevorzugt höchstens 20:1 und noch mehr bevorzugt höchstens 15:1. Wird zu wenig Aktivator eingesetzt, so besteht die Gefahr, dass die Reaktion wesentlich länger dauert, wodurch das Verfahren dann nicht mehr effizient durchgeführt werden kann. In ganz besonders bevorzugten Ausführungsformen liegt das Molverhältnis von Gallium zu dem Aktivator zwischen 1,3:1 und 12:1, weiter bevorzugt zwischen 2:1 und 10:1.

Die Gewichtsverhältnisse von Gallium zum Aktivator, Verbindung (A), liegen bevorzugt im Bereich von etwa 1:5 bis 12:1.

Für die Herstellung der Eduktmischung, also erfindungsgemäß der Mischung umfassend Gallium, Alkyldonor und Aktivator, werden die einzelnen Komponenten einem Reaktionsgefäß zugesetzt. Bevorzugt werden Gallium und der Alkyldonor dem Reaktionsgefäß zeitlich versetzt, also nacheinander zugesetzt. Besonders bevorzugt wird zunächst eine Vormischung umfassend Gallium und Aktivator im Reaktionsgefäß vorgelegt und anschließend der Alkyldonor zugesetzt. Dies führt überraschenderweise zu hohen Ausbeuten und vereinfachte zudem den apparativen Aufwand. So kann Gallium und Aktivator in den Reaktor einfach eingewogen werden. Anschließend kann eine kontrollierte Zugabe des Alkyldonors erfolgen, der regelmäßig unter Normbedingungen nach DIN 1343:1990 im gasförmigen Aggregatzustand vorliegt.

Die Zugabe des Alkyldonors erfolgt bevorzugt dadurch, dass der Alkyldonor, der bei Normbedingungen im Allgemeinen gasförmig vorliegt (Siedepunkt von MeCl liegt bei -24°C, von EtCl bei 12°C), durch kontrolliertes kontinuierliches Einleiten in flüssigem oder gasförmigem Zustand der Reaktion zugeführt wird. Im Reaktor bzw. unter Reaktionsbedingungen liegt der Alkyldonor gasförmig vor.

Beim Einleiten wird während des Reaktionsverlaufes vorzugsweise immer soviel Alkyldonor nachgeliefert, wie verbraucht wurde, so dass der Reaktions(über)druck konstant gehalten wird. Die Steuerung erfolgt zum Beispiel automatisch über ein mit einem Dosierventil gekoppelten Drucksensor.

Bevorzugt wird der Alkyldonor flüssig in den Reaktor geleitet. Es wird im Regelfall nicht von Anfang an die gesamte benötigte Menge an Alkyldonor zugegeben, sondern permanent Alkyldonor zudosiert, bis die Umsetzung vollständig ist.

Die Dosierung des flüssigen Alkyldonors kann zum Beispiel unter Druck direkt aus einem Flüssiggas-Tank erfolgen. Im Reaktor verdampft der Alkyldonor durch die herrschenden Reaktionsbedingungen sofort, so dass die Umsetzung im Reaktor mit gasförmigem Alkyldonor erfolgt.
In einer anderen Ausführungsform wird der Alkyldonor, wie beispielsweise Methylchlorid, gasförmig bei Raumtemperatur in den Reaktor geleitet und dann auf die gewünschte Reaktionstemperatur erhitzt und die Einleitung von Alkyldonor währenddessen fortgesetzt.

Es kann hierbei unter Inertgas wie Argon oder Stickstoff gearbeitet werden, es ist aber auch möglich, die Reaktion ohne zusätzliches Inertgas in einer reinen Atmosphäre aus Alkyldonor, wie beispielsweise Methylchlorid oder Ethylchlorid, durchzuführen, was Vorteile hat.

Die Zugabe des Alkyldonors erfolgt bei einem vorgegebenen konstanten, absoluten Druck von 1,5 bar bis 6 bar oder 2 bar bis 4,5 bar (Überdruck von 1 bar bis 3,5 bar).

Hierbei kann so vorgegangen werden, dass ein gewünschter Überdruck an Alkyldonor (also z.B Ethylchlorid oder Methylchlorid), wie beispielsweise 3,5 bar, vorgegeben wird. Über einen Durchflussregler wird immer so viel an Alkyldonor (also z.B. Ethylchlorid oder Methylchlorid), in den Reaktor nachgeliefert wie verbraucht wird, so dass der Druck im Reaktor in etwa konstant, also beispielsweise bei 4,5 bar (bzw. der Überdruck bei 3,5 bar), bleibt. Wird kein Alkyldonor (also z.B. Ethylchlorid oder Methylchlorid) mehr verbraucht wird, so ist die Reaktion beendet. Da bei der Reaktion gasförmige Nebenprodukte wie Ethen oder Methan entstehen können, hat es sich bewährt, gelegentlich den Überdruck im Reaktor abzulassen und diesen neu mit Alkyldonor zu beschicken. Dies kann insbesondere dann vorteilhaft sein, wenn trotz Gegenwart der Ausgangsstoffe kein Verbrauch von Alkyldonor beobachtet werden kann, was aber zwangsläufig der Fall ist, wenn eine Reaktion mit dem Alkyldonor stattfindet.

In einer anderen Ausführungsform wird die benötigte Menge an Alkyldonor bereits zu Beginn der Reaktion vollständig im Reaktionsgefäß vorgelegt. In dieser Ausführungsform erfolgt die Zugabe des Alkyldonors bevorzugt durch Einkondensieren des Alkyldonors. Vorzugsweise wird in dieser Ausführungsform die Vormischung nach deren Herstellung zunächst abgekühlt. Als vorteilhaft hat es sich erwiesen, die Vormischung abzukühlen auf Temperaturen von höchstens 10°C, bevorzugt höchstens 5°C und weiter bevorzugt unter 4°C. Ganz besonders vorteilhaft ist es, wenn die Vormischung auf eine Temperatur von 0°C +/- 3°C abgekühlt wird.

Vorzugsweise wird das Reaktionsgefäß nach dem Abkühlen der Vormischung evakuiert. Bevorzugt erfolgt dann die Zugabe des Alkyldonors bei Temperaturen zwischen -100°C und -260°C, weiter bevorzugt zwischen -150°C und -250°C und noch mehr bevorzugt bei Temperaturen zwischen -180°C und -220°C. Die Zugabe des Alkyldonors umfasst vorzugsweise ein Einkondensieren des Alkyldonors in das Reaktionsgefäß, mehr bevorzugt erfolgt die Zugabe des Alkyldonors durch Einkondensieren des Alkyldonors. Eine solche Verfahrensführung hat sich als vorteilhaft erwiesen, um zur Vormischung verfahrenstechnisch einfach eine definierte Menge an Alkyldonor zuzuführen. Unter den erfindungsgemäß bevorzugten Verfahrensbedingungen wird der regelmäßig unter Normalbedingungen gasförmig vorliegende Alkyldonor verflüssigt und kann so leicht im Reaktionsgefäß abgewogen werden.

Nach Zugabe des Alkyldonors wird die Eduktmischung bevorzugt erhitzt um die Reaktion zu starten. Das Erhitzen kann ein vorgelagertes Erwärmen auf Temperaturen zwischen 15°C und 35°C, bevorzugt auf Raumtemperatur, also 25 +/- 5°C, umfassen. Die Eduktmischung wird, vorzugsweise nach dem vorgelagerten Erwärmen, auf Temperaturen von wenigstens 100°C erhitzt, weiter bevorzugt wenigstens 120°C. Die Temperatur sollte nicht zu niedrig sein, weil dann sehr lange Reaktionszeiten erforderlich sind zur Erzielung einer ausreichenden Ausbeute.

Das Verfahren ist dann weniger kosteneffektiv. Beim Erhitzen sollten aber Temperaturen von vorzugsweise 300°C, weiter bevorzugt 230°C und mehr bevorzugt 200°C nicht überschritten werden. Das Verfahren wird dann zu aufwändig und es besteht die Gefahr von unerwünschten Nebenreaktionen.

Die Bildung von Verbindung (A) ist exotherm, bevorzugt ist deshalb nach Erhitzen der Eduktmischung auf wenigstens 100 °C ein weiteres Erhitzen des Reaktionsgefäßes nicht erforderlich, sondern es wird bei einer konstanten Reaktionstemperatur gehalten. Bevorzugt wird das Reaktionsgefäß durch Kühlung bei konstanter Reaktionstemperatur gehalten

Als besonders vorteilhaft für eine hohe Ausbeute und eine hohe Reinheit an Verbindung (A), RGaCl₂ bzw. ein Gemisch von R₂GaCl/RGaCl₂, hat es sich erwiesen, wenn die Reaktionstemperatur zwischen 120°C und 190°C, insbesondere zwischen 140°C bis 180°C, oder von 130°C und 170°C sowie ganz besonders bevorzugt bei Temperaturen von 140°C bis 160°C, oder von ca. 150 +/- 5°C gehalten wird.

In Ausführungsformen, in denen der Alkyldonor bereits zu Beginn der Reaktion vollständig zugeführt wird, kann der Druck im Reaktionsgefäß nach dem Erhitzen ganz besonders bevorzugt wenigstens 4 bar betragen. Ein zu geringer Druck führt zu langen Reaktionszeiten, was das Verfahren insgesamt kostenintensiv gestaltet. Als besonders bevorzugt hat es sich erwiesen, wenn der Druck im Reaktionsgefäß nach dem Erhitzen zwischen 2 und 6 bar oder 2 bis 5 bar beträgt.

Wird der Alkyldonor kontinuierlich zugeführt, so können Solldrücke zwischen (absolut) 1,5 bis 6 bar, bevorzugt 2 bis 4,5 bar (absolut, entspricht einem Überdruck von 1 bis 3,5 bar) mit Erfolg eingesetzt werden. Bei den Reaktionstemperaturen ist der Alkyldonor bei diesen Drücken meist gasförmig.

Die Reaktionstemperaturen, werden bevorzugt für wenigstens 20 min, weiter bevorzugt wenigstens 30 min und mehr bevorzugt für wenigstens 40 min aufrechterhalten. Werden diese Temperaturen zu kurze Zeit aufrechterhalten, besteht die Gefahr, dass die Reaktion nicht quantitativ erfolgt. Erfindungsgemäß ist es aber vorzugsweise nicht erforderlich, die Temperaturen für mehr als 50 Stunden aufrechtzuerhalten. Es wird insbesondere bedingt durch die erfindungsgemäße Verfahrensführung und die erfindungsgemäße Zusammensetzung der Eduktmischung vorzugsweise bereits innerhalb von 50 Stunden, bevorzugt 28 Stunden und mehr bevorzugt innerhalb von 25 Stunden eine ausreichende Umsetzung erzielt. Meist können mit 6 bis 12 Stunden, insbesondere 6 bis 8 Stunden gute Ergebnisse erreicht werden. Dies ist vorteilhaft, da das erfindungsgemäße Verfahren dadurch besonders kosteneffektiv durchgeführt werden kann.

In Ausführungsformen, in denen der Aktivator GaCl₃ oder eine Mischung von GaCl₃ und RGaCl₂ ist, waren bereits bei Aufrechterhaltung der vorzugsweise durch Erhitzen erhaltenen Temperaturen für wenigstens 45 min, bevorzugt wenigstens 50 min ausreichende Ausbeuten an Verbindung (A) erhältlich.

Nach Aufrechterhaltung der Reaktionstemperaturen für den oben aufgeführten bevorzugten Zeitraum, oder wenn kein metallisches Ga mehr vorliegt, oder kein Alkyldonor mehr aufgenommen wird, wird die im Reaktionsgefäß vorliegende Mischung, nachfolgend als Reaktionsgemisch bezeichnet, auf Temperaturen zwischen 15°C und 35°C, bevorzugt auf Raumtemperatur, also 25 +/- 5°C, abgekühlt. In einer anderen Ausführungsform wird die Alkyldonor-Zufuhr unterbrochen und das Produkt ohne Abkühlung direkt flüssig aus dem Reaktor abgelassen oder in ein anderes Gefäß gepumpt.

### Reaktionsschritt a2):

Die optionale Isolierung von Verbindung (A), RGaCl₂ bzw. R₂GaCl/RGaCl₂-Mischung, erfindungsgemäß als Reaktionsschritt a2) bezeichnet, umfasst bevorzugt das Abtrennen etwaiger nicht umgesetzter Edukte aus dem Reaktionsgemisch und/oder das Entfernen von RGaCl₂ bzw. R₂GaCl/RGaCl₂-Mischung aus dem Reaktionsgefäß. Dies kann beispielsweise durch mechanisches Entfernen von RGaCl₂ bzw. R₂GaCl/RGaCl₂-Mischung oder das Sublimieren von RGaCl₂ bzw. R₂GaCl/RGaCl₂-Mischung aus dem Reaktionsgefäß bewirkt werden.

Vorzugsweise erfolgt das Entfernen nicht umgesetzter Edukte aus dem Reaktionsgemisch, insbesondere des regelmäßig bei Normbedingungen gasförmig vorliegenden Alkyldonors, durch Evakuieren des Reaktionsgefäßes, optional bei Temperaturen zwischen 5°C und -5°C, weiter bevorzugt bei 0 +/- 3°C oder Raumtemperatur.

Das RGaCl₂ bzw. R₂GaCl/RGaCl₂-Mischung kann nach Entfernung nicht umgesetzter Edukte aus dem Reaktionsgemisch aus dem Reaktionsgefäß mechanisch entfernt werden. Mechanische Entfernung umfasst auch das Ablassen oder Überdrücken/umpumpen des Reaktionsproduktes im flüssigen Zustand. Alternativ kann RGaCl₂ bzw. R₂GaCl/RGaCl₂-Mischung aus dem Reaktionsgefäß sublimiert werden. Dabei sind bei kleineren Ansatzgrößen die mechanische Entfernung von Vorteil, im industriellen Maßstab hat das Sublimieren den Vorteil, daß in einem vollständig geschlossenen System gearbeitet werden kann, welches keines Eingriffs von außen mehr bedarf.

An das Isolieren können sich weitere Reinigungsschritte des RGaCl₂ bzw. der R₂GaCl/RGaCl₂-Mischung anschließen, wobei dem Fachmann geeignete Verfahren zur Reinigung chemischer Stoffe bekannt sind, wie zum Beispiel Sublimieren oder Umkristallisieren, was mit gutem Erfolg aus unpolaren Verbindungen wie Kohlenwasserstoffen durchgeführt werden kann. Aromatische oder aliphatische Kohlenwasserstoffe können prinzipiell beide verwendet werden, entweder einzeln oder als Mischung. Zur Umkristallisation geeignete Stoffe sind beispielsweise Benzol, Toluol, Hexan, Heptan, Oktan, Benzin, Petrolether oder Ähnliches. Vorzugsweise sind jedoch keine weiteren Reinigungsschritte des RGaCl₂ bzw. der R₂GaCl/RGaCl₂-Mischung erforderlich zur Erzielung einer ausreichenden Reinheit. Es erfolgen also erfindungsgemäß neben dem Abtrennen nicht umgesetzter Edukte aus dem Reaktionsgemisch und vorzugsweise dem anschließenden mechanischen Entfernen von RGaCl₂ bzw. R₂GaCl/RGaCl₂-Mischung aus dem Reaktionsgefäß oder dessen Sublimation keine weiteren Isolierungs- und/oder Reinigungsschritte.

In alternativen Ausführungsformen erfolgt keine Isolierung des RGaCl₂, bzw. R₂GaCl/RGaCl₂-Mischung also umfasst Schritt a) in diesen Ausführungsformen keinen Reaktionsschritt a2). In solchen Ausführungsformen kann sich Schritt b) direkt im selben Reaktionsgefäß anschließen ohne vorherige Isolierung des RGaCl₂. bzw. der R₂GaCl/RGaCl₂-Mischung Eine solche Verfahrensführung kann dazu beitragen, dass die Herstellung von Trialkylgallium-Verbindung insgesamt noch kosteneffektiver und schneller möglich wird bei hoher Reinheit der erhaltenen Trialkylgallium-Verbindung.

Es ist erfindungsgemäß nicht erforderlich, Wasserstoff (H₂) als Reaktionsbeschleuniger während des Verfahrensschrittes a1) einzusetzen. Auch kann erfindungsgemäß auf den Einsatz von Iod oder Brom oder Galliumtriiodid bzw. Galliumtribromid, die in bisherigen Verfahren üblicherweise für eine vollständige Umsetzung von Gallium zu Galliumalkylhalogenid-Verbindungen zugesetzt werden mussten, verzichtet werden. Letzteres ist besonders vorteilhaft in Hinblick auf die Reinheit von RGaCl₂. bzw. R₂GaCl/RGaCl₂-Mischung

Mit dem erfindungsgemäßen Verfahrensschritt a1) können unter Abwesenheit organischer Lösungsmittel hohe Ausbeuten an RGaCl₂ bzw. R₂GaCl/RGaCl₂-Mischung erzielt werden. Vorzugsweise wird bei der Reaktion von Gallium mit dem Alkyldonor unter Anwesenheit eines Aktivators zur Bildung von RGaCl₂ bzw. R₂GaCl/RGaCl₂-Mischung also kein organisches Lösungsmittel eingesetzt. Unter organischen Lösungsmitteln werden erfindungsgemäß kohlenstoffhaltige, flüssige Substanzen verstanden. Unter Abwesenheit eines organischen Lösungsmittels wird erfindungsgemäß verstanden, dass kein organisches Lösungsmittel zusätzlich als Reaktionsmedium eingesetzt wird. Dies hat den Vorteil, dass mögliche organische Verunreinigungen im RGaCl₂ bzw. R₂GaCl/RGaCl₂-Mischung durch partielle Zersetzung des Lösungsmittels vermieden werden. Darüber hinaus kann das Verfahren hierdurch umweltschonender durchgeführt werden. Außerdem konnte bei Abwesenheit organischer Lösungsmittel im Schritt a1) überraschenderweise eine besonders hohe Selektivität der Reaktion verzeichnet werden.

Der erfindungsgemäße Verfahrensschritt a) ermöglicht die Herstellung von RGaCl₂ bzw. R₂GaCl/RGaCl₂-Mischung mit einer Ausbeute von vorzugsweise wenigstens 70%, weiter bevorzugt wenigstens 75%, noch weiter bevorzugt wenigstens 79% und ganz besonders bevorzugt von 85% und noch weiter bevorzugt über 90% sowie ganz besonders bevorzugt von mehr als 95%. Erfindungsgemäße Angaben zur Ausbeute sind stets auf die theoretische Ausbeute bezogen.

Die Reinheit des erfindungsgemäß hergestellten RGaCl₂ bzw. R₂GaCl/RGaCl₂-Mischung beträgt vorzugsweise wenigstens 95%, bevorzugt wenigstens 98% und besonders bevorzugt mehr als 99%. Es sind also vorzugsweise nicht mehr als 5%, bevorzugt nicht mehr als 2% und weiter bevorzugt unter 1% Verunreinigungen, also unerwünschte Substanzen, im hergestellten RGaCl₂ bzw. R₂GaCl/RGaCl₂-Mischung enthalten. Dem Fachmann sind Verfahren zur Ermittlung der Reinheit einer chemischen Verbindung wohlbekannt.

In einer besonders bevorzugten Ausführungsform des erfindungsgemäßen Verfahrens läuft im Reaktionsschritt a) schematisch folgende Reaktion ab (Me = Methyl):

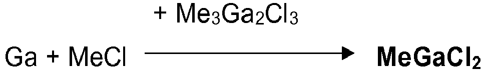

In einer alternativen Ausführungsform des erfindungsgemäßen Verfahrens läuft im Reaktionsschritt a) schematisch folgende Reaktion ab:

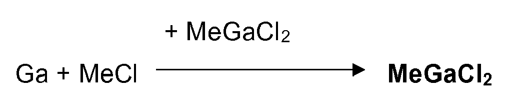

In einer weiteren alternativen Ausführungsform des erfindungsgemäßen Verfahrens läuft im Reaktionsschritt a) schematisch folgende Reaktion ab:

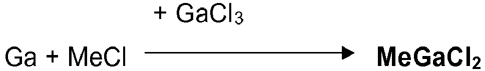

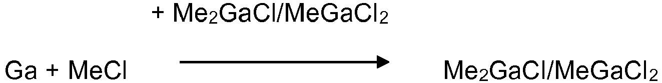

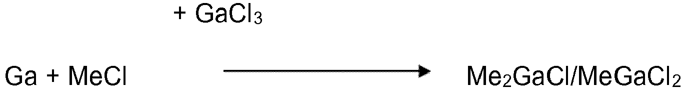

Das erfindungsgemäß hergestellte RGaCl₂ bzw. R₂GaCl/RGaCl₂-Mischung kann für die Herstellung von Trialkylgallium-Verbindung eingesetzt werden, es kann sich also unmittelbar oder zeitlich versetzt Schritt b) anschließen, was eine gezielte und bedarfsgerechte Herstellung von Trialkylgallium-Verbindung möglich macht.

### b) Herstellung von Trialkylgallium-Verbindung aus Alkylgalliumdichlorid bzw. R₂GaCl/RGaCl₂-Mischung

Die Herstellung von Trialkylgallium-Verbindung aus RGaCl₂ bzw. R₂GaCl/RGaCl₂-Mischungen erfolgt erfindungsgemäß durch Reaktion von RGaCl₂ bzw. R₂GaCl/RGaCl₂-Mischung mit einer Metallalkyl-Komponente.

Die Metallalkyl-Komponente ist eine Verbindung, die wenigstens ein Metallatom und eine Alkylgruppe umfasst und hat folgende allgemeine Formel:

**R_{d}MₑX_{f},**

wobei d eine Zahl ausgewählt aus 1, 2 und 3 ist und e eine Zahl ausgewählt aus 1 und 2 ist und f eine Zahl ausgewählt aus 0, 1, 2 und 3 ist und wobei d und f nicht gleichzeitig 0 sind. R ist wie oben definiert. M ist ausgewählt aus Aluminium, Lithium und Magnesium, besonders bevorzugt ist M Aluminium oder Lithium. X ist ausgewählt aus Cl, Br und I, bevorzugt ist X Cl.

In bevorzugten Ausführungsformen ist M = Aluminium, e = 1 oder 2 und die Summe aus d, e und f = 4 oder 8, wobei d ≠ 0 ist und X = Cl ist, erfindungsgemäß als "Aluminiumalkyl-Komponente" bezeichnet. In alternativen Ausführungsformen ist M = Magnesium, d = 1, e = 1 und f = 1 und X = Cl, erfindungsgemäß als "Magnesiumalkyl-Komponente" bezeichnet. In weiteren alternativen Ausführungsformen ist M = Lithium, d = 1, e = 1 und f = 0, was erfindungsgemäß als "Lithiumalkyl-Komponente" bezeichnet wird.

Ganz besonders bevorzugt ist die Metallalkyl-Komponente ausgewählt aus RMgCl, R₂AlCl, R₃Al, R₃Al₂Cl₃ und RLi, weiter bevorzugt ausgewählt aus R₂AlCl, R₃Al, R₃Al₂Cl₃ und noch mehr bevorzugt ausgewählt aus R₃Al und R₃Al₂Cl₃, insbesondere Me₃Al, Et₃Al, Me₃Al₂Cl₃ und Et₃Al₂Cl₃.

Die jeweils erforderliche Menge an Metallalkyl-Komponente im Verhältnis zu RGaCl₂ bzw. R₂GaCl/RGaCl₂-Mischung wird durch die Anzahl der Alkylgruppen der Metallalkyl-Komponente bestimmt. Bei Einsatz von R₂GaCl/RGaCl₂ Mischung zur Herstellung von R₃Ga wird die Menge an Metallakylkomponente zusätzlich durch das Verhältnis von R₂GaCl zu RGaCl₂ in der Mischung, also durch die Anzahl der Alkylgruppen in der Mischung bestimmt. Die Metallalkyl-Komponente wird also jeweils in einer solchen Menge eingesetzt, dass quantitativ Trialkylgallium-Verbindung gebildet werden kann. In Ausführungsformen, in denen die Metallalkyl-Komponente eine Aluminiumalkyl-Komponente ist, kann das Molverhältnis der Metallalkyl-Komponente zu RGaCl₂ zwischen 0,7:1 bis 4:1 betragen, bevorzugt zwischen 0,9:1 und 3,5:1, weiter bevorzugt zwischen 1:1 und 2:1. Bei Einsatz einer 50/50 Mischung von R₂GaCl/RGaCl₂-Mischung kann zum Beispiel das Molverhältnis der Aluminiumalkyl-Kompente zur R₂GaCl/RGaCl₂-Mischung zwischen 1:1 bis 6:1 betragen. Bei anderen Zusammensetzungen der R₂GaCl/RGaCl₂-Mischung können die benötigten Verhältnisse leicht berechnet werden. In Ausführungsformen, in denen die Metallalkyl-Komponente eine "Magnesiumalkyl-Komponente" oder eine "Lithiumalkyl-Komponente" ist, beträgt das Molverhältnis der Metallalkyl-Komponente zu RGaCl₂ üblicherweise zwischen 1,9:1 bis 4:1, bevorzugt zwischen 2:1 und 2,8: Bei Einsatz einer 50/50 R₂GaCl/RGaCl₂-Mischung kann zum Beispiel das Molverhältnis zwischen 2,9:1 und 6:1, bevorzugt 2:1 bis 3:1.

Die Reaktion von Metallalkyl-Komponente mit RGaCl₂ bzw. R₂GaCl/RGaCl₂-Mischung kann in einem organischen Lösungsmittel erfolgen. Geeignete organische Lösungsmittel für Schritt b) sind ausgewählt aus Alkanen einschließlich von cyclischen gesättigten Kohlenwasserstoffen, cyclischen und aliphatischen Ethern und aromatischen Kohlenwasserstoffen, die Heteroatome und/oder Substituenten aufweisen können. Als organische Lösungsmittel für Schritt b) haben sich insbesondere Alkane, Aromaten und cyclische und aliphatische Ether als geeignet erwiesen, bevorzugt ausgewählt aus *n*-Pentan, Cyclohexan, Cycloheptan, *n*-Decan, *n*-Heptan, *n*-Hexan, *n*-Nonan, *n*-Octan und Benzol, Toluol, Xylol, Diethylether, längerkettige Ether, Tetrahydrofuran und Mischungen daraus. Längerkettige Ether sind solche, die Alkylgruppen mit mehr als 2 C-Atomen umfassen, besonders bevorzugt ist der längerkettige Ether Di-*n*-butylether.

In bevorzugten Ausführungsformen wird jedoch kein organisches Lösungsmittel im Reaktionsschritt b) eingesetzt, also kein organisches Lösungsmittel zusätzlich als Reaktionsmedium eingesetzt. Dies hat den Vorteil, dass mögliche, die Anwendbarkeit für MOCVD- oder MOVPE-Verfahren erheblich einschränkende organische Verunreinigungen in der Trialkylgallium-Verbindung durch partielle Zersetzung des Lösungsmittels vermieden werden. Darüber hinaus kann das Verfahren hierdurch umweltschonender durchgeführt werden. In einer erfindungsgemäßen Ausführungsform wird Schritt b) daher unter Abwesenheit organischer Lösungsmittel durchgeführt.

Es kann beim Reaktionsschritt b) ferner eine Hilfsbase zugesetzt werden, was einen positiven Einfluss auf die Ausbeute an Trialkylgallium-Verbindung haben kann. Geeignete Hilfsbasen im Schritt b) sind ausgewählt aus Natriumchlorid, Kaliumchlorid, Aluminiumchlorid und Mischungen davon. Ganz besonders bevorzugt ist eine Mischung aus Natriumchlorid und Kaliumchlorid, vorzugsweise liegt das Molverhältnis von Natriumchlorid zu Kaliumchlorid in der Hilfsbase zwischen 6:4 und 8:2, weiter bevorzugt zwischen 6:3 und 8:3 und besonders bevorzugt zwischen 6,5:3 und 7,5:3. In alternativen Ausführungsformen, in denen die Hilfsbase eine Mischung aus Aluminiumchlorid, Natriumchlorid und Kaliumchlorid ist, beträgt das Molverhältnis von Aluminiumchlorid zu Natriumchlorid zu Kaliumchlorid bevorzugt 45 bis 55 zu 30 bis 40 zu 10 bis 20, besonders bevorzugt 50 zu 35 zu 15.

Vorzugsweise wird RGaCl₂ bzw. R₂GaCl/RGaCl₂-Mischung mit der optionalen Hilfsbase im Reaktionsgefäß vorgelegt und erst anschließend wird die Metallalkyl-Komponente zugesetzt, vorzugsweise langsam. Die Temperatur, bei der die Reaktion stattfindet, wird in Abhängigkeit von der Metallalkyl-Komponente gewählt. Vorzugsweise findet die Reaktion bei Temperaturen zwischen 0°C und 250°C, bevorzugt bei 20°C und 180°C und weiter bevorzugt bei Temperaturen zwischen 30°C und 150°C statt. In Ausführungsformen, in denen eine Hilfsbase verwendet wird, beträgt die Temperatur bevorzugt bis zu 230°C, weiter bevorzugt bis zu 200°C. Die Temperatur beträgt in solchen Ausführungsformen jedoch vorzugsweise wenigstens 30°C.

Die Trialkylgallium-Verbindung wird nachfolgend isoliert vom restlichen Gemisch, wobei dies das Entfernen optionaler organischer Lösungsmittel sowie anderer Bestandteile des Gemischs umfassen kann. Vorzugsweise wird die Trialkylgallium-Verbindung vom Gemisch durch Abdestillieren isoliert. In Ausführungsformen, in denen eine Hilfsbase zugesetzt wird, wird die Trialkylgallium-Verbindung bevorzugt über ein beheizbares Trennelement isoliert, insbesondere eine beheizbare Kolonne. Hierzu kann im einfachsten Fall ein temperierbares Trennelement wie ein Rohr dienen, aber auch z.B. Vigreux-Kolonnen, Füllkörperkolonnen oder andere Kolonnen. Derartige Trennelemente werden auch als Separator bezeichnet, wie aus der WO 2013/83450 bekannt ist. Deren Inhalt wird hiermit in diese Anmeldung aufgenommen. Optional können sich weitere Reinigungsschritte anschließen nach dem Fachmann bekannten Reinigungsverfahren, insbesondere ein Abdestillieren oder eine Sublimation der Trialkylgallium-Verbindung.

Der erfindungsgemäße Verfahrensschritt b) ermöglicht die Herstellung von Trialkylgallium mit einer Ausbeute von vorzugsweise wenigstens 70%, weiter bevorzugt wenigstens 70%, noch weiter bevorzugt wenigstens 75% und ganz besonders bevorzugt von wenigstens 85% sowie noch weiter bevorzugt über 90%. Die Reinheit des erfindungsgemäß hergestellten Trialkylgallium beträgt vorzugsweise wenigstens 99%, bevorzugt wenigstens 99,5% und besonders bevorzugt mehr als 99,8% sowie weiter bevorzugt mehr als 99,999%. Das hergestellte Trialkylgallium enthält Sauerstoff einschließlich Galliumalkoxiden und -oxiden, in einer Menge von vorzugsweise unter 100 ppm (m/m), bevorzugt unter 50 ppm (m/m) und noch mehr bevorzugt unter 30 ppm (m/m) und ganz besonders bevorzugt unter 10 ppm (m/m). Der Sauerstoffgehalt beziehungsweise der Gehalt sauerstoffhaltiger Verunreinigungen im Trialkylgallium kann unter Verwendung dem Fachmann bekannter Verfahren, insbesondere NMR, ermittelt werden.

In einer besonders bevorzugten Ausführungsform des erfindungsgemäßen Verfahrens läuft im Reaktionsschritt b) schematisch folgende Reaktion ab:

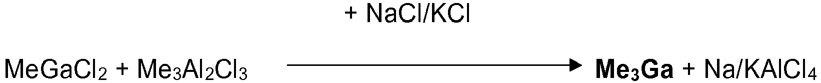

Bzw. bei Einsatz einer R₂GaCl/RGaCl₂-Mischung:

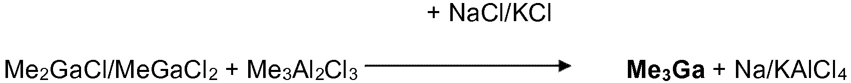

In einer alternativen Ausführungsform des erfindungsgemäßen Verfahrens läuft im Reaktionsschritt b) schematisch folgende Reaktion ab:

MeGaCl₂ + Me₃Al → **Me₃Ga**

MeGaCl₂ + MeLi → **Me₃Ga**

MeGaCl₂ + MeMgCl → **Me₃Ga**

Me₂GaCl/MeGaCl₂ + Me3Al → **Me₃Ga**

Me₂GaCl/MeGaCl₂ + MeLi → **Me₃Ga**

Me₂GaCl/MeGaCl₂ + MeMgCl → **Me₃Ga**

Durch die Einhaltung der Bedingungen des oben dargestellten erfindungsgemäßen Herstellverfahrens kann Trialkylgallium-Verbindung in hoher Ausbeute und mit hoher Reinheit hergestellt werden. Erfindungsgemäß ist zudem das nach dem Verfahren hergestellte Alkylgalliumdichlorid, bzw. die Dialkylgalliumchlorid/Alkylgalliumdichlorid-Mischung, insbesondere Methylgalliumdichlorid bzw. Me₂GaCl/MeGaCl₂, als Zwischenstufe, und die daraus hergestellte Trialkylgallium-Verbindung, insbesondere Trimethylgallium. Bei der Verwendung von Lithium- oder Grignard-Spezies als Metallalkyl-Komponente, wie z.B. Methyllithium oder Methylmagnesiumchlorid, können gute Ergebnisse bei Durchführung der Reaktion in einem Lösemittel erzielt werden. Als Lösemittel gut geeignet sind zum Beispiel Ether, wir Diethylether, Di-n-butylether, Methyl-tert.-butylether, Ethyl-tert.-butylether, DIoxan oder Tetrahydrofuran.

Insbesondere die mögliche hohe Ausbeute und Reinheit an RGaCl₂ bzw. R₂GaCl/RGaCl₂-Mischung und R₃Ga sowie die kosteneffiziente und wenig umweltbelastende Prozesswahl des erfindungsgemäßen Verfahrens prädestiniert das Verfahren zur industriellen Herstellung von Trialkylgallium-Verbindungen.

Das erfindungsgemäße Verfahren ist insbesondere durch eine besonders hohe Gallium-Ausnutzung gekennzeichnet. Der Gallium-Gesamtumsatz des erfindungsgemäßen Verfahrens bezogen auf das eingesetzte Gallium beträgt vorzugsweise ≥ 70%, weiter bevorzugt ≥ 75%, besonders bevorzugt ≥ 80% und noch mehr bevorzugt > 95%.

Die mit dem erfindungsgemäßen Verfahren herstellbare Trialkylgallium-Verbindung, insbesondere Trimethylgallium, eignet sich aufgrund der hervorragenden Reinheit, insbesondere des sehr niedrigen Sauerstoffgehaltes, besonders als metallorganischer Präkursor für die MOCVD oder MOVPE, beispielsweise zur Herstellung von Halbleitern oder Halbleiter-Bauelementen. Die schlussendlich hergestellten Halbleiter oder Halbleiter-Bauelemente sind vielseitig industriell einsetzbar. Erfindungsgemäß ist daher auch die Verwendung der erfindungsgemäß hergestellten Trialkylgallium-Verbindung, vorzugsweise Trimethylgallium, als Präkursor für die metallorganische chemische Gasphasenabscheidung (MOCVD) oder die metallorganische Gasphasenepitaxie (MOVPE).

### Ausführungsbeispiele zur Herstellung von Trimethylgallium

Es wurde Trimethylgallium nach dem erfindungsgemäßen Verfahren hergestellt über die Zwischenstufe Methylgalliumdichlorid.

### 1. Herstellung von Methylgalliumdichlorid

### 1.1. Reaktion von Gallium mit Methylchlorid in Anwesenheit von Me₃Ga₂Cl₃ als Aktivator (in situ gebildet, Molverhältnis Gallium zu Aktivator: etwa 8,8:1)

In einer 250 ml-Parrbombe wurden 1.17 g Gallium (16.8 mmol), 0.21 g Me₃Ga (1.9 mmol) und 0.32 g GaCl₃ (1.8 mmol) zusammen mit einem Magnetrührstab eingewogen. Das Gefäß wurde auf 0°C gekühlt und evakuiert. Anschließend wurden bei -196°C 3.06 g Methylchlorid (60.7 mmol) in die Parrbombe einkondensiert und diese nach Erwärmen auf Raumtemperatur auf 160°C erhitzt. Nach 24 Stunden bei 160°C hatte sich Gallium komplett aufgelöst, dann wurde die Parrbombe auf Raumtemperatur abgekühlt und nach Erreichen der Raumtemperatur wurde die Parrbombe bei 0°C evakuiert, um Reste von Methylchlorid zu entfernen und den Massenzuwachs zu bestimmen. Anschließend wurde die Parrbombe in einer Glovebox geöffnet und das MeGaCl₂ wurde mechanisch isoliert. Die MeGaCl₂-Ausbeute betrug laut Massenzuwachs 3.18 g (20.4 mmol, 99%). Mechanisch isoliert wurden davon 2.57 g (16.5 mmol, 80%). Identifikation erfolgte per NMR und IR.

### 1.2. Reaktion von Gallium mit Methylchlorid in Anwesenheit von MeGaCl₂ (Molverhältnis Gallium zu Aktivator: etwa 1,7:1)

In einer 250 mL Parrbombe wurden 1.14 g Gallium (16.4 mmol) und 1.46 g Me-GaCl₂ (9.4 mmol) zusammen mit einem Magnetrührstab eingewogen. Das Gefäß wurde auf 0°C gekühlt und evakuiert. In die Parrbombe wurden bei -196°C 2.99 g Methylchlorid (59.2 mmol) einkondensiert und nach Erwärmen auf Raumtemperatur wurde das Gefäß auf 160°C erhitzt. Nach 21 Stunden bei 160°C hatte sich Gallium komplett aufgelöst, dann wurde die Parrbombe auf Raumtemperatur abgekühlt. Anschließend wurde die Parrbombe auf 0°C gekühlt und evakuiert, um Reste von Methylchlorid zu entfernen und den Massenzuwachs zu bestimmen. Die Parrbombe wurde in einer Glovebox geöffnet und das MeGaCl₂ wurde isoliert. Die MeGaCl₂-Ausbeute betrug laut Massenzuwachs 4.03 g (25.9 mmol, 99%). Mechanisch isoliert wurden davon 3.87 g (24.9 mmol, 96%). Identifikation erfolgte per NMR und IR.

### 1.3. Reaktion von Gallium mit Methylchlorid in Anwesenheit von GaCl₃ (Molverhältnis Gallium zu GaCl₃: 2:1)

In einer 125 ml-Parrbombe wurden 0.70 g Gallium (10.0 mmol) und 0.89 g GaCl₃ (5.0 mmol) zusammen mit einem Magnetrührstab vorgelegt. Das Gefäß wurde auf 0°C gekühlt und evakuiert. Anschließend wurde die Parrbombe auf -196°C gekühlt und 1.03 g Methylchlorid (20.4 mmol) einkondensiert. Nach Erwärmen auf Raumtemperatur wurde das Gefäß auf 160°C erhitzt. Nach 90 min bei 160°C hatte sich Gallium komplett aufgelöst, dann wurde die Parrbombe auf Raumtemperatur abgekühlt und anschließend bei 0°C evakuiert, um Reste von Methylchlorid zu entfernen und den Massenzuwachs zu bestimmen. Die Parrbombe wurde in einer Glovebox geöffnet und das MeGaCl₂ wurde isoliert. In der Parrbombe verblieben Reste von MeGaCl₂, die sich mechanisch nicht entfernen ließen. Die MeGaCl₂-Ausbeute betrug laut Massenzuwachs 2.28 g (14.6 mmol, 98%). Mechanisch isoliert wurden davon 1.94 g (12.5 mmol, 83%). Identifikation erfolgte per NMR und IR.

### 1.4. Reaktion von Gallium mit Methylchlorid in Anwesenheit von GaCl₃ (Molverhältnis Gallium zu GaCl₃: 2:1, zusätzlich Reste von MeGaCl₂ im Reaktionsgefäß)

Verwendet wurde die 125 ml-Parrbombe aus dem vorhergehenden Beispiel 1.3. Die Parrbombe sowie der Magnetrührstab wurden nicht gereinigt, die Reste von MeGaCl₂ verblieben in der Parrbombe. In die Parrbombe wurden 0.70 g Gallium (10.0 mmol) und 0.89 g GaCl₃ (5.0 mmol) zusammen mit einem Magnetrührstab vorgelegt. Das Gefäß wurde auf 0°C abgekühlt und evakuiert. In die Parrbombe wurden bei -196°C 1.18 g Methylchlorid (23.4 mmol) einkondensiert. Nach Erwärmen auf Raumtemperatur wurde das Gefäß auf 160°C erhitzt. Während der Reaktion war die Schmelze dunkel gefärbt. Nach 60 min bei 160°C wurde die Parrbombe auf Raumtemperatur abgekühlt und anschließend bei 0°C evakuiert, um Reste von Methylchlorid zu entfernen und den Massenzuwachs zu bestimmen. Die Parrbombe wurde in einer Glovebox geöffnet und das MeGaCl₂ wurde isoliert. In der Parrbombe verblieben Reste von MeGaCl₂, die sich mechanisch nicht entfernen ließen. Im Vergleich zum vorhergehenden Ansatz war das isolierte Me-GaCl₂ braun gefärbt. Die MeGaCl₂-Ausbeute betrug laut Massenzuwachs 2.24 g (15.4 mmol, quantitativ bezogen auf eingesetztes Ga und GaCl₃). Mechanisch isoliert wurden 2.54 g (16.3 mmol). Identifikation erfolgte per NMR und IR.

Die kombinierte Masse des gebildeten MeGaCl₂ aus den Beispielen 1.3 und 1.4 beträgt 4.62 g MeGaCl₂ (29.7 mmol, Ausbeute: 99%). Dies isolierte Ausbeute beider Versuche beträgt 4,48 g MeGaCl₂ (28.8 mmol, 96%).

### 1.5 Reaktion von Gallium mit Methylchlorid in Anwesenheit von Me₂GaCl/MeGaCl₂-Gemisch und kontinuierlicher Zuführung des Alkyldonors

In einem 1L-Druckreaktor wurden 86,63 g (1,24 mol) Gallium vorgelegt. Der Reaktor wurde durch dreimaliges Evakuieren/Fluten mit Argon inertisiert, nach der letzten Evakuierung wurde der Reaktor statt mit Argon mit Chlormethan auf Normaldruck gebracht. Über einen auf 90 °C beheizten Tropftrichter wurden 198,77 g Me₂GaCl/MeGaCl₂-Gemisch (aus einer vorherigen Charge) flüssig in den Reaktor abgelassen. Zum Start der Reaktion wurde das Reaktionsgemisch unter Rühren auf 150 °C aufgeheizt und 5 bar Chlormethan (absolut, entsprechend 4 bar Überdruck) auf den Reaktor gedrückt. Das Anspringen der Reaktion war an einer beginnenden Gasaufnahme und einer Exothermie zu erkennen. Die MeCl-Zufuhr in den Reaktor wurde so geregelt, dass der Reaktionsdruck konstant bei 5 bar gehalten wurde. Die Reaktionstemperatur wurde durch Kühlung des Reaktors auf 150 °C gehalten. Nach etwa vier Stunden war die Gasaufnahme der Reaktion unter 100 mL/min gesunken, obwohl noch Gallium in der Schmelze vorhanden war, deshalb wurde der Überdruck des Reaktors abgelassen, anschließend erneut 5 bar MeClaufgedrückt und die Reaktion weitergeführt. Nach einer weiteren halben Stunde war kein Gallium mehr im Reaktor sichtbar und die Reaktion nam kein Gas mehr auf. Die Gaszufuhr wurde gestoppt und das Reaktionsgemisch auf Raumtemperatur abgekühlt. Der im Reaktor verbleibende Überdruck wurde abgelassen und anschließend wurde der Reaktor zur Entfernung des restlichen Chlormethans und flüchtiger Nebenprodukte evakuiert und mit Argon auf Normaldruck gebracht.

Zur Isolierung des Produktes wurde der Reaktor auf 70 °C aufgeheizt, dadurch schmolz das Reaktionsprodukt und wurde im Vakuum bei 80-100 °C aus dem Reaktor herausdestilliert. Es konnten 377,42 g eines weißen, kristallinen Feststoffes erhalten werden. Das 1H-NMR (600 MHz, CD3CN) zeigte zwei Singuletts bei -0,09 ppm und 0,14 ppm im Verhältnis von 0,39 zu 1, die einer (C*H*₃)₂GaCl- und einer (C*H*₃)GaCl₂-Einheit zugeordnet werden konnten. Dies entspricht einem molaren Me2GaCl/MeGaCl2-Verhältnis von ca. 28/72. Die Gallium-Ausbeute bezogen auf das eingesetzte metallische Gallium betrug 92,3%. Die Reinheit des isolierten Produktes betrug 95,9%.

### 1.6 Umsetzung von Gallium mit MeCl in Anwesenheit von GaCl₃ und kontinuierlicher Zuführung von Alkyldonor

In einem inerten 1L-Druckreaktor wurden 105,2 g (1,51 mol) Gallium und 127,9 g (0,73 mol) GaCl₃ vorgelegt. Der Reaktor wurde evakuiert und mit Chlormethan beaufschlagt. Das Reaktionsgemisch wurde unter Rühren auf 150 °C aufgeheizt und bei einem Soll-Überdruck von 4,5 bar im Verlauf von 1,5 Stunden mit max. 1000 mL/min Chlormethan bei 150 °C in den Reaktor geleitet, bis alles Gallium verbraucht war und kein Chlormethan mehr verbraucht wurde. Der Gesamtverbrauch an Chlormethan betrug 58 L. Der Überdruck im Reaktor wurde abgelassen, der Reaktor abgekühlt und ca. 1/3 des Reaktionsproduktes flüssig aus dem Reaktor in einen Schlenkkolben abgelassen. Der Rest des Reaktionsproduktes wurde auf Raumtemperatur abgekühlt und verblieb für den Einsatz im nächsten Versuch als Feststoff im Reaktor.

Es wurden 163,3 g Me₂GaCl/MeGaCl₂-Gemisch als kristalliner, weißer Feststoff isoliert. ¹H-NMR (600 MHz, CD₃CN) δ -0,02 (s, (CH₃)₂Ga), 0,18 (s, CH₃Ga); Integralverhältnis 1 zu 9, dies entspricht einem molaren Me₂GaCl/MeGaCl₂-Verhältnis von ca. 5/95.

### 1.7 Umsetzung von Gallium mit MeCI in Anwesenheit von Me₂GaCl/Me-GaCl₂-Gemisch und kontinuierlicher Zuführung von Alkyldonor

In den Reaktor mit dem Me₂GaCl/MeGaCl₂-Gemisch aus dem vorherigen Beispiel wurden 101,6 g (1,46 mol) Gallium gegeben. Anschließend wurde das Reaktionsgemisch erneut unter Rühren auf 150 °C aufgeheizt und bei einem Soll-Überdruck von 4,5 bar im Verlauf von 2 Stunden bei 150 °C mit max. 1000 mL/min Chlormethan in den Reaktor geleitet, bis alles Gallium verbraucht war und kein Chlormethan mehr verbraucht wurde. Der Gesamtverbrauch an Chlormethan betrug 55,5 L. Der Überdruck im Reaktor wurde abgelassen, der Reaktor abgekühlt und bei 100 °C ca. 1/3 des Reaktionsproduktes flüssig aus dem Reaktor in einen Schlenkkolben abgelassen. Der Rest des Reaktionsproduktes wurde auf Raumtemperatur abgekühlt und verblieb wieder für den Einsatz im nächsten Versuch als Feststoff im Reaktor. Das isolierte Produkt wurde durch Sublimation im Vakuum gereinigt.

Es wurden 169,6 g Me₂GaCl/MeGaCl₂-Gemisch als kristalliner, weißer Feststoff isoliert. ¹H-NMR (600 MHz, C₆D₆) δ 0,17 (s, (CH₃)₂Ga), 0,28 (s, CH₃Ga); Integralverhältnis 1 zu 1,49, dies entspricht einem molaren Me₂GaCl/MeGaCl₂-Verhältnis von ca. 25/75; Ga-Gehalt: 47,4%.

### 1.8 Umsetzung von Gallium mit MeCI in Anwesenheit von Me₂GaCl/Me-GaCl₂-Gemisch und kontinuierlicher Zuführung von Alkyldonor

In den Reaktor mit dem Me₂GaCl/MeGaCl₂-Gemisch aus dem vorherigen Beispiel wurden 105,6 g (1,51 mol) Gallium gegeben. Anschließend wurde das Reaktionsgemisch erneut unter Rühren auf 150 °C aufgeheizt und bei einem Soll-Überdruck von 4,5 bar Chlormethan in den Reaktor geleitet. Die Reaktionstemperatur wurde bei 150 °C gehalten. Nach vier Stunden ging der Gasverbrauch stark zurück, daraufhin wurde der Druck des Reaktors abgelassen und mit frischem Chlormethan erneut auf den Soll-Überdruck gebracht. Es wurde für weitere 1,5 Stunden Chlormethan eingeleitet bis alles Gallium verbraucht war. Der Gesamtverbrauch an Chlormethan betrug 55,5 L. Der Überdruck im Reaktor wurde abgelassen, der Reaktor abgekühlt und bei 100 °C ca. 1/3 des Reaktionsproduktes flüssig aus dem Reaktor in einen Schlenkkolben abgelassen. Der Rest des Reaktionsproduktes wurde auf Raumtemperatur abgekühlt und verblieb wieder für den Einsatz im nächsten Versuch als Feststoff im Reaktor. Das isolierte Produkt enthielt noch geringe Mengen an kurzkettigen Kohlenwasserstoffen als Verunreinigung und wurde durch Sublimation im Vakuum gereinigt. Es wurden 192,2 g Me₂GaCl/MeGaCl₂-Gemisch als kristalliner, weißer Feststoff isoliert. ¹H-NMR (600 MHz, CD₃CN) δ -0,10 (s, (CH₃)₂Ga), 0,14 (s, CH₃Ga); Integralverhältnis 1 zu 1,13, dies entspricht einem molaren Me₂GaCl/MeGaCl₂-Verhältnis von ca. 30/70.
¹H-NMR (600 MHz, CD₃CN) δ -0,10 (s, 6H, (-Ga(C*H*₃)₂), 0,14 (s, 3H, (-Ga(CH₃))

### Herstellung von Trimethylgallium

### 2.1 Umsetzung von Methylgalliumdichlorid zu Trimethylgallium

In einem 500 mL-Kolben mit Rührer und einem auf 70°C temperierten Separator wurden unter Schutzgas 1.94 g (12.5 mmol) MeGaCl₂ aus Beispiel 1.1, 1.2 oder
1.3, 1.02 g (17,5 mmol) trockenes NaCl und 0.56 g (7.5 mmol) trockenes KCl vorgelegt. Unter Rühren wurden 2.56 g (2.2 ml, 12.5 mmol) Me₃Al₂Cl₃ so zugegeben, dass die Temperatur im Reaktionsgemisch nicht über 130°C stieg. Beim anschließenden Hochheizen konnte ab ca. 150°C Me₃Ga (1.25 g (10,9 mmol, 87.6% Direktausbeute bezogen auf eingesetztes MeGaCl₂,) isoliert werden. Die Produktisolierung über den Separator wurde beendet, als die Reaktionstemperatur über 200°C stieg, danach wurden über einen zweiten Ausgang im Hochvakuum restliche Gallium-enthaltende Verbindungen aus dem Reaktionsgemisch entfernt (0.095 g, Gemisch aus Me₃Ga und Me₂GaCl). Gesamtausbeute: 94.8% Me₃Ga, 5.0% Me₂GaCl, Gesamtumsatz Gallium: 99.8%.

### 2.2 Reaktion von Gallium mit Methylchlorid in Anwesenheit von GaCl₃ (Molverhältnis Gallium zu GaCl₃: 2:1) mit anschließender Umsetzung zu Trimethylgallium

In einer 125 mL-Parrbombe wurden 1.39 g Gallium (19.9 mmol) und 1.76 g GaCl₃ (10.0 mmol) eingewogen und nach Evakuieren wurden 1.87 g Methylchlorid (37.0 mmol) einkondensiert. Die Parrbombe wurde eine Stunde lang auf 160°C erhitzt. In dieser Zeit löste sich das Gallium vollständig auf und es wurde eine farblose Schmelze beobachtet. Nach Abpumpen des überschussigen Methylchlorides konnte ein Massenzuwachs von 1.60 g bestimmt werden. Das entspricht einer quantitativen Umsetzung des Ga/GaCl₃-Gemisches zu MeGaCl₂. In die Parrbombe wurden anschließend 1,63 g NaCl (27,9 mmol), 0,89 g KCl (11,9 mmol) und 4,06 g Methylaluminiumsesquichlorid (19.7 mmol) eingewogen. Über Nacht wurde die Parrbombe auf 130-140°C erhitzt. Nach Abkühlen auf Raumtemperatur wurden die flüchtigen Bestandteile im Vakuum in eine auf -196°C gekühlte Kühlfalle kondensiert. Dabei wurde die Parrbombe im Vakuum auf 160°C erhitzt. In die Kühlfalle gelangt ein Gemisch aus Me₂GaCl und GaMe₃. Das flüchtigere GaMe₃ wurde bei Normaldruck in eine weitere auf -196°C gekühlte Kühlfalle kondensiert. Es wurden 3.46 g Me₂GaCl (25.6 mmol, 86%) und 0.18 g GaMe₃ (1.6 mmol, 5%) isoliert.

## Patentansprüche

1. Verfahren zur Herstellung einer Verbindung (A), welche entweder der allgemeinen Formel
RGaCl₂ entspricht oder eine Mischung ist von RGaCl₂ mit R₂GaCl, umfassend die Reaktionsschritte
a1) Reaktion von Gallium mit einem Alkyldonor in Anwesenheit eines Aktivators zur Bildung von Verbindung (A),;
a2) und optional Isolierung der Verbindung (A) vom Reaktionsgemisch, wobei R ein verzweigter oder unverzweigter Alkylrest mit 1 bis 4 Kohlenstoffatomen ist und die Zugabe des Alkyldonors bei einem vorgegebenem konstantem Druck von 1,5 bis 6 bar erfolgt,
der Alkyldonor die allgemeine Formel hat:
**RCl**
wobei R wie oben definiert ist und in Schritt a1) gasförmig vorliegt, und
der Aktivator eine Verbindung oder eine Mischung von Verbindungen folgender allgemeiner Formel ist:
**RₐGa_{b}Cl_{c},**
wobei a eine Zahl ausgewählt aus 0, 1, 2 und 3 ist und b eine Zahl ausgewählt aus 1 und 2 ist und c eine Zahl ausgewählt aus 0, 1, 2 und 3 ist, wobei a und c nicht gleichzeitig 0 sind, und wobei a + b + c = 4 oder ein Vielfaches von 4 sind und wobei R wie oben definiert ist und wobei die Summe aus a und c gleich 3 ist, wenn b gleich 1 ist, oder wobei die Summe aus a und c gleich 6 ist, wenn b gleich 2 ist.

2. Verfahren nach Anspruch 1, wobei der Aktivator ausgewählt ist aus GaCl₃, R₂GaCl, R₃Ga₂Cl₃, RGaCl₂ und Mischungen davon, oder eine Mischung aus R₂GaCl und RGaCl₂ oder wobei das Reaktionsprodukt, Verbindung (A), selbst als Aktivator eingesetzt wird.

3. Verfahren nach einem der vorangegangenen Ansprüche, wobei R Methyl oder Ethyl ist, vorzugsweise Methyl.

4. Verfahren nach einem der vorangegangenen Ansprüche, wobei das Molverhältnis von Alkyldonor zu Gallium wenigstens 1,4:1 beträgt.

5. Verfahren nach wenigstens einem der vorangegangenen Ansprüche, wobei eine Vormischung aus Gallium und Aktivator im Reaktionsschritt a1) im Reaktionsgefäß vorgelegt wird und der Alkyldonor anschließend zugesetzt wird.

6. Verfahren nach einem der vorangegangenen Ansprüche, wobei der Reaktionsschritt a1) unter Abwesenheit organischer Lösungsmittel durchgeführt wird.

7. Verfahren zur Herstellung einer Verbindung (B) der allgemeinen Formel:
**R₃Ga**
wobei eine Verbindung (A) nach einem oder mehreren der vorstehenden Ansprüche bereitgestellt wird, und
b) Reaktion der Verbindung (A) mit einer Metallalkyl-Komponente, wobei eine Verbindung (B) der allgemeinen Formel:
**R₃Ga**
erhalten wird, wobei R wie in einem der vorstehenden Ansprüche definiert ist.

8. Verfahren nach Anspruch 7, wobei die Metallalkyl-Komponente die allgemeine Formel aufweist:
**R_{d}MₑX_{f}**
wobei d eine Zahl ausgewählt aus 1, 2 und 3 ist und e eine Zahl ausgewählt aus 1 und 2 ist und f eine Zahl ausgewählt aus 0, 1, 2 und 3 ist, und wobei d und f nicht gleichzeitig 0 sind, und wobei R wie oben definiert ist, und wobei M ausgewählt ist aus Aluminium, Lithium und Magnesium, und wobei X ausgewählt ist aus Cl, Br und I.

9. Verfahren nach Anspruch 8, wobei M Aluminium ist, e = 1 oder 2 ist und die Summe aus d, e und f = 4 oder 8 ist, und wobei d ≠ 0 ist, und wobei X = Cl ist.

10. Verfahren nach einem der Ansprüche 7 bis 8, wobei die Metallalkyl-Komponente ausgewählt ist aus RMgCl, R₂AlCl, R₃Al, R₃Al₂Cl₃ und RLi, insbesondere Me₃Al, Et₃Al, Me₃Al₂Cl₃ und Et₃Al₂Cl₃..

11. Verfahren nach einem der Ansprüche 7 bis 10, wobei im Reaktionsschritt b) ferner eine Hilfsbase zugesetzt wird, wobei die Hilfsbase ausgewählt ist aus Natriumchlorid, Kaliumchlorid, Aluminiumchlorid und Mischungen davon.

12. Verfahren nach einem oder mehreren der Ansprüche 1 bis 11, wobei die Verbindung (A) eine Mischung der Verbindungen R₂GaCl und RGaCl₂ ist, wobei R wie oben definiert ist und das Verhältnis von R₂GaCl zu RGaCl₂ von 10:90 bis 90:10, insbesondere 10:90 bis 50:50, insbesondere von 20:80 bis 40:60, bezogen auf die molaren Mengen beträgt.

## Claims

1. A method for preparing a compound (A), which either corresponds to the general formula
RGaCl₂ or is a mixture of RGaCl₂ with R₂GaCl, comprising the reaction steps of
a1) reacting gallium with an alkyl donor in the presence of an activator to form compound (A),
a2) and optionally isolating said compound (A) from the reaction mixture,
wherein R is a branched or unbranched alkyl group having 1 to 4 carbon atoms, and the alkyl donor is added at a predetermined constant pressure of from 1.5 to 6 bar,
the alkyl donor has the general formula:
**RCl**
wherein R is as defined above and is gaseous in step a1), and
the activator is a compound or a mixture of compounds of the following general formula:
**RₐGa_{b}Cl_{c},**
wherein a is a number selected from 0, 1, 2 and 3; and b is a number selected from 1 and 2; and c is a number selected from 0, 1, 2 and 3; wherein a and c are not simultaneously 0; and wherein a + b + c = 4 or a multiple of 4; and wherein R is as defined above; and wherein the sum of a and c is equal to 3 when b is equal to 1; or wherein the sum of a and c is equal to 6 when b is equal to 2.

2. The method according to claim 1, wherein the activator is selected from GaCl₃, R₂GaCl, R₃Ga₂Cl₃, RGaCl₂, and mixtures thereof, or a mixture of R₂GaCl and RGaCl₂; or wherein the reaction product, compound (A), is itself used as an activator.

3. The method according to any one of the preceding claims, wherein R is methyl or ethyl, preferably methyl.

4. The method according to any one of the preceding claims, wherein the molar ratio of alkyl donor to gallium is at least 1.4:1.

5. The method according to at least one of the preceding claims, wherein a premix of gallium and activator is initially placed in the reaction vessel in reaction step a1), and the alkyl donor is added subsequently.

6. The method according to any one of the preceding claims, wherein reaction step a1) is performed in the absence of organic solvents.

7. A method for preparing a compound (B) having the general formula:
**R₃Ga**
wherein a compound (A) according to one or more of the preceding claims is provided, and
b) reacting said compound (A) with a metal alkyl component, wherein a compound (B) having the general formula:
**R₃Ga**
is obtained, wherein R is as defined in any one of the preceding claims.

8. The method according to claim 7, wherein the metal alkyl component has the general formula:
**R_{d}MₑX_{f}**
wherein d is a number selected from 1, 2 and 3; and e is a number selected from 1 and 2; and f is a number selected from 0, 1, 2 and 3; and wherein d and f are not simultaneously 0; and wherein R is as defined above; and wherein M is selected from aluminum, lithium and magnesium; and wherein X is selected from Cl, Br and I.

9. The method according to claim 8, wherein M is aluminum; e = 1 or 2; and the sum of d, e and f = 4 or 8; and wherein d is 0; and wherein X = Cl.

10. The method according to any one of claims 7 through 8, wherein the metal alkyl component is selected from RMgCl, R₂AlCl, R₃Al, R₃Al₂Cl₃, and RLi, in particular Me₃Al, Et₃Al, Me₃Al₂Cl₃, and Et₃Al₂Cl₃.

11. The method according to any one of claims 7 through 10, wherein an auxiliary base is also added in reaction step b), wherein the auxiliary base is selected from sodium chloride, potassium chloride, aluminum chloride, and mixtures thereof.

12. The method according to one or more of claims 1 through 11, wherein the compound (A) is a mixture of the compounds R₂GaCl and RGaCl₂, wherein R is as defined above, and the ratio of R₂GaCl to RGaCl₂ is from 10:90 to 90:10, in particular 10:90 to 50:50, in particular from 20:80 to 40:60, relative to the molar amounts.

## Revendications

1. Procédé de préparation d'un composé (A), qui correspond soit à la formule générale
RGaCl₂ soit est un mélange de RGaCl₂ avec R₂GaCl, comprenant les étapes de réaction
a1) réaction du gallium avec un donneur d'alkyle en présence d'un activateur pour former le composé (A) ;
a2) et isolement facultatif du composé (A) à partir du mélange réactionnel,
R étant un résidu alkyle ramifié ou non ramifié avec 1 à 4 atomes de carbone et l'ajout du donneur d'alkyle est effectué à une pression constante prédéfinie de 1,5 à 6 bar,
le donneur d'alkyle a la formule générale :
**RCl**
dans laquelle R est tel que défini ci-dessus et est présent sous forme gazeuse à l'étape a1) et
l'activateur est un composé ou un mélange de composés de formule générale suivante :
**RₐGa_{b}Cl_{c},**
dans laquelle a est un nombre choisi parmi 0, 1, 2 et 3 et b est un nombre choisi parmi 1 et 2 et c est un nombre choisi parmi 0, 1, 2 et 3, dans laquelle a et c ne sont pas simultanément égaux à 0 et dans laquelle a + b + c = 4 ou un multiple de 4 et dans laquelle R est tel que défini ci-dessus et dans laquelle la somme de a et c est égale à 3, lorsque b est égal à 1 ou dans laquelle la somme de a et c est égale à 6, lorsque b est égal à 2.

2. Procédé selon la revendication 1, dans lequel l'activateur est choisi parmi GaCl₃, R₂GaCl, R₃Ga₂Cl₃, RGaCl₂ et des mélanges de ceux-ci ou un mélange de R₂GaCl et RGaCl₂ ou dans lequel le produit de réaction, le composé (A), est utilisé lui-même comme activateur.

3. Procédé selon l'une des revendications précédentes, dans lequel R est un méthyle ou un éthyle, de préférence un méthyle.

4. Procédé selon l'une des revendications précédentes, dans lequel le rapport molaire du donneur d'alkyle au gallium est d'au moins 1,4:1.

5. Procédé selon au moins une des revendications précédentes, dans lequel un prémélange de gallium et d'activateur dans l'étape de réaction a1) est introduit dans le récipient de réaction et le donneur d'alkyle est ajouté ensuite.

6. Procédé selon l'une des revendications précédentes, dans lequel l'étape de réaction a1) est réalisée en absence d'un solvant organique.

7. Procédé de préparation d'un composé (B) de formule générale :
**R₃Ga**
dans lequel un composé (A) selon une ou plusieurs des revendications précédentes est préparé et
b) réaction du composé (A) avec un composant métal-alkyle, dans lequel un composé (B) de formule générale :
**R₃Ga**
est obtenu, dans lequel R est tel que défini dans l'une des revendications précédentes.

8. Procédé selon la revendication 7, dans lequel le composant métal-alkyle présente la formule générale :
**R_{d}MₑX_{f}**
dans laquelle d est un nombre choisi parmi 0, 1, 2 et 3 et e est un nombre choisi parmi 1 et 2 et f est un nombre choisi parmi 0, 1, 2 et 3 et dans laquelle d et f ne sont pas simultanément égaux à 0 et dans laquelle R est tel que défini ci-dessus et dans laquelle M est choisi parmi l'aluminium, le lithium et le magnésium et dans laquelle X est choisi parmi Cl, Br et I.

9. Procédé selon la revendication 8, dans lequel M est l'aluminium, e = 1 ou 2 et la somme de d, e et f = 4 ou 8 et dans lequel d est différent de 0 et dans lequel X = Cl.

10. Procédé selon l'une des revendications 7 à 8, dans lequel le composant métal-alkyle est choisi parmi RMgCl, R₂AlCl, R₃Al, R₃Al₂Cl₃ et RLi, en particulier Me₃Al, Et₃Al, Me₃Al₂Cl₃ et Et₃Al₂Cl₃.

11. Procédé selon l'une des revendications 7 à 10, dans lequel à l'étape de réaction b), une base auxiliaire est également ajoutée, la base auxiliaire étant choisie parmi le chlorure de sodium, le chlorure de potassium, le chlorure d'aluminium et des mélanges de ceux-ci.

12. Procédé selon une ou plusieurs des revendications 1 à 11, dans lequel le composé (A) est un mélange des composés R₂GaCl et RGaCl₂, dans lequel R est tel que défini ci-dessus et le rapport de R₂GaCl à RGaCl₂ est de 10:90 à 90:10, en particulier de 10:90 à 50:50, en particulier de 20:80 à 40:60, par rapport aux quantités molaires.
